(19) **Europäisches Patentamt / European Patent Office / Office européen des brevets**

(11) **EP 1 369 745 B1**

(12) **EUROPEAN PATENT SPECIFICATION**

(45) Date of publication and mention of the grant of the patent:
**27.02.2013 Bulletin 2013/09**

(51) Int Cl.:
*G03F 7/20* (2006.01)       *B23Q 1/58* (2006.01)
*B23Q 11/00* (2006.01)      *B60T 13/74* (2006.01)
*G03F 9/00* (2006.01)

(21) Application number: **03253564.3**

(22) Date of filing: **05.06.2003**

(54) **Lihographic apparatus and device manufaturing method**

Lithographischer Apparat und Verfahren zur Herstellung einer Vorrichtung

Appareil lithographique et méthode de fabrication d'un dispositif

(84) Designated Contracting States:
**DE FR GB IT NL**

(30) Priority: **07.06.2002 EP 02253970**

(43) Date of publication of application:
**10.12.2003 Bulletin 2003/50**

(73) Proprietor: **ASML Netherlands B.V.**
**5504 DR Veldhoven (NL)**

(72) Inventors:
• **Cox, Henrikus Herman Marie**
**5646 JH Eindhoven (NL)**
• **Van Ballegoij, Robertus Nicodemus Jacobus**
**5644 KK Eindhoven (NL)**
• **Vosters, Petrus Matthijs Henricus**
**5531 EH Eindhoven (NL)**

• **Hol, Sven Antoin Johan**
**5623 AW Eindhoven (NL)**
• **Cornelissen, Simon Maria Jan**
**5653 RN Eindhoven (NL)**

(74) Representative: **Slenders, Petrus J. W. et al**
**ASML Netherlands B.V.**
**Corporate Intellectual Property**
**P.O. Box 324**
**5500 AH Veldhoven (NL)**

(56) References cited:
EP-A- 0 502 578          EP-A- 1 111 470
EP-A2- 0 917 004         US-A- 5 815 246
US-A- 5 844 666          US-A- 5 953 105
US-A1- 2001 006 762      US-A1- 2002 012 108
US-B1- 6 262 796

## Description

The present invention relates to a lithographic projection apparatus comprising:

- a radiation system for supplying a projection beam of radiation;
- a support structure for supporting patterning means, the patterning means serving to pattern the projection beam according to a desired pattern;
- a substrate table for holding a substrate;
- a projection system for projecting the patterned beam onto a target portion of the substrate;
- a base frame;
- a balance mass with 3 degrees of freedom, the three degrees of freedom being in the horizontal plane; and
- a positioning actuator connected between said substrate table or said support structure and said balance mass for generating a reaction force between said balance mass and said substrate table or said support structure thereby to position said substrate table or said support structure relative to said projection system in the three degrees of freedom in the horizontal plane, wherein said balance mass is coupled to said base frame in the 3 degrees of freedom in the horizontal plane via an elastic coupling so that said balance mass has a suspension eigenfrequency of between 0.3 and 10 Hz such that a portion of said reaction force is exerted on said base frame.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:

- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
- A programmable mirror array. One example of such a device is a matrix-addressable surface having a viscoelastic control layer and a reflective surface.

The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field (electromagnetic, electrostatic), or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096. In the case of a programmable mirror array, the said support structure may be embodied as a frame or table, for example, which may be fixed or movable as required.

- A programmable LCD array. An example of such a construction is given in United States Patent US 5,229,872. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (e.g. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus -commonly referred to as a step-and-scan apparatus - each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791.

In a lithographic projection apparatus, the information on a Mask that is positioned on a support structure, is projected on the Substrate table in a so-called scanning process, where the support structure and substrate table move synchronously at constant speed. The acceleration or deceleration forces can be high because the acceleration of the substrate table can typically be of the order of 5 to 100 m/s² and a substrate table might typically weigh about 10-200 [Kg]. If this substrate table is moved by an actuator that is attached to a Base Frame, the reaction force is transferred to this base frame. If this reaction force is directly transferred to the Base Frame, this results in large excitations of the Base Frame Eigen Frequencies (typically 10 to 50 [Hz]). This results in Base Frame vibrations that disturb the Vibration Isolation System of the Projection Lens. Part of the vibration can then be transmitted to the Projection Lens. Because the Substrate Table is positioned relative to the Projection Lens, this Projection Lens vibration will generate servo position errors, affecting the imaging process.

The effect of such a reaction force can be reduced by use of a freely mounted balance mass as described in US patent 6,262,796. This is done by generating a reaction force using a positioning actuator between the substrate table and the balance mass such that the substrate table is moved in one direction whilst the balance mass is moved in the opposite direction by an amount equal to the distance moved by the substrate table times the mass ratio of the substrate table to the balance mass. In this way, no substantial reaction forces are transmitted to the base frame and the combined center of gravity of the balance mass and the substrate table relative to the base frame stays substantially constant.

If such freely mounted balance mass has a large stroke, the balance mass requires guidance in its movement and the transmission of cables and tubes carrying utilities to the balance mass, in particular if the balance mass is in a vacuum, can be difficult to arrange and results in a large machine.

In an attempt to minimize the size of lithographic projection apparatus the mass of the balance mass can be increased to reduce the stroke required of the mass balance at the cost of extra complexity in the near frictionless support of the balance mass.

The above problems are equally applicable to the support structure for supporting the patterning means which also needs to move relative to the projection system and can be moved with the use of a balance mass.

US 2002/0012108 discloses a lithographic apparatus in accordance with the pre-characterizing section of claim 1.

EP-A2-0,917,004 discloses a stage system, comprising: a first stage movable along a reference plane, containing a vertical direction, and in the vertical direction or in a first direction close to the vertical direction; a second stage movable in a second direction intersecting with the first direction and relative to the first stage; a first driving mechanism for moving the first stage in the first direction; a second driving mechanism for moving the second stage in the second direction; a countermass movable in the first direction; and a third driving mechanism for moving the countermass in a direction opposite to the first direction.

US 2001/0006762 and EP-A2-1,111,470 disclose the use of balance masses for positioning of a stage.

It is an object of the present invention to provide an alternative to the freely mounted balance mass that at least partly eliminates one of the above mentioned problems.

This and other objects are achieved according to the invention in a lithographic apparatus as specified in the opening paragraph, characterized by further comprising a balance mass actuator for controlling the position of said balance mass, and in that the balance mass is supported by the base frame via a bearing.

In this way, only part of the reaction force is transmitted to the base frame through the elastic coupling. An eigen frequency of between 0.3 and 10 Hz of the balance mass is preferred because then only low frequency vibrations are transmitted to the base frame as follows: reaction forces generated by movement of the substrate table or support structure at frequencies above about 10 to 15 Hz are hardly transmitted to the base frame as at these frequencies the balance mass is unaffected by the elastic coupling and behaves almost as a free balance mass for these frequencies. Unwanted disturbances of the substrate table or support structure typically are disturbances with frequencies well above 10 Hz but the balance mass does not transfer significant disturbances in this frequency region. However, acceleration forces generated by long stroke operations of the substrate table or support structure, which typically have an energy with a frequency of below 10 Hz, are transmitted to the base frame. Part of the reaction force on the balance mass is taken up by the spring stiffness of the elastic coupling and this requires a small stroke. It has been found that such low frequency forces transmitted to the base frame can be quite high in magnitude before they have a deleterious effect on the apparatus. In this way, in a typical lithographic projection apparatus according to the present invention the stroke of the balance mass is typically less than about 20 mm. The elastic coupling may as an example comprise of leaf-springs, torsional springs or other mechanical springs, magnet assemblies with spring-like characteristics, etc. Furthermore, it is noted that, the elastic coupling has the tendency to move the balance mass to its neutral position. This yields for example, advantages during initialization of said positioning actuator.

The balance mass actuator can be positioned in parallel with said elastic coupling, wherein the balance mass is also coupled to said base frame via said balance mass actuator. This balance mass actuator may be used to apply position correction forces to the balance mass at a low frequency. In this way, large but low frequency forces in the translational direction can be applied to the base frame at low frequency. The balance mass actuator may also enable a damping of the resonance frequency of the Balance Mass system (formed by the mass of the Balance Mass and the stiffness to Base Frame of the elastic coupling) and a further decrease in force transfer in the frequency range above 10Hz between the base frame and the balance mass.

The bearing can, as an example, be an air bearing between the base frame and the balance mass. This provides a support allowing the balance mass to make the required stroke in the translational direction.

In an embodiment according to the present invention , the apparatus is constructed and arranged such that on movement during positioning of said substrate table or said support structure the position of the combined center of gravity of said substrate table or said support structure and said balance mass relative to said base frame also moves. Due to the elastic coupling of the balance mass to the base frame, the center of gravity will not maintain its position on movement during positioning of said substrate table or said support structure.

In an embodiment of the present invention, a filtered feed forward program is applied to the balance mass actuator to smooth out the forces passed to the base frame. The balance mass actuator may, for example be a pneumatic, hydraulic, electromagnetic or piezo-electric actuator.

In an embodiment of the present invention, the balance mass is damped with a damper with a damping coefficient, b, of between 0.3 and 0.9, preferably 0.65 to 0.75. In this way long stroke reaction forces of the substrate table applied to the base frame cannot amplify.

In an embodiment of the present invention, the damper is positioned in parallel with said elastic coupling, wherein the balance mass is also coupled to said base frame via said damper. The damping may be realized by a separate component or can be obtained by the elastic coupling itself with internal damper.

In an embodiment of the present invention, the balance mass is damped with a damping coefficient, b, which is varied as a function of frequency. As an example, an Eddy current damper may be applied. Also, in case a balance mass actuator is used for actively damping vibrations of said balance mass the damping coefficient can be varied as a function of frequency.

In an embodiment of the present invention, the apparatus further comprises a controller for periodically applying a position control loop. This may, as an example be applied to prevent drift of said balance mass due to repetitive motions of said substrate table or support structure or to compensate for friction of the balance mass or to correct hysteresis effects of the elastic coupling.

In an embodiment of the present invention, between 50 and 100 % of the reaction force with a frequency below 3 to 10 Hz is exerted by said elastic coupling on said base frame.

In an embodiment of the present invention, the apparatus further comprises a vacuum chamber containing the substrate table or support structure and the balance mass. The balance mass of the present invention is particularly suited to such applications because of its small stroke.

In an embodiment of the present invention, a bellows is applied between the balance mass and a wall of the vacuum chamber. This is possible because of the small stroke of the balance mass and is advantageous because any cables and tubes to provide utilities to the balance mass, for example, such as air for air bearings or electrical cables for positional sensors, can be routed through the bellows and do not therefore need to be vacuum compliant.

In an embodiment of the present invention the bellows form at least part of the elastic coupling. Depending on the stiffness, the bellows may partly or completely take over the function of the elastic coupling between the balance mass and the base frame.

In an embodiment of the present invention, the balance mass actuator or the spring-damper system is connected with said balance mass through said bellows.

According to a further aspect of the invention there is provided a device manufacturing method comprising the steps of: providing a substrate that is at least partially covered by a layer of radiation-sensitive material on a substrate table positioned on a base frame; providing a projection beam of radiation using a radiation system; using patterning means supported on a support structure to endow the projection beam with a pattern in its cross-section; projecting the patterned beam of radiation onto a target portion of the layer of radiation-sensitive material; providing a balance mass with 3 degrees of freedom, the 3 degrees of freedom being in the horizontal plane; moving said substrate table or said support structure relative to said base frame in the 3 degrees of freedom in the horizontal plane by generating a reaction force between said substrate table or said support structure and the balance mass, transmitting part of said reaction force to said base frame through an elastic coupling which couples said balance mass to said base frame in the 3 degrees of freedom in the horizontal plane with a suspension eigenfrequency of between 0. 3 and 10 Hz, characterized by controlling the position of the balance mass by using a balance mass actuator and by supporting the balance mass on the base frame via a bearing.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (e.g. with a wavelength of 365, 248, 193, 157 or 126 nm) and EUV (extreme ultra-violet radiation, e.g. having a wavelength in the range 5-20 nm), as well as particle beams, such as ion beams or electron beams.

Embodiments of the invention will now be described, by way of example only, with reference to the accompanying schematic drawings in which:

Figure 1 depicts the relevant parts of a lithographic projection apparatus;

Figure 2 depicts a lithographic projection apparatus;

Figure 3 depicts a lithographic projection apparatus suitable for vacuum applications;

Figure 4 depicts a typical force pattern during the scanning process in both time and frequency domain;

Figure 5 depicts the transfer of the reaction force to the base frame in the frequency domain for different arrangements.

Figure 6 depicts the transfer function of the Balance Mass displacement to the base frame force in the frequency domain for different arrangements.

Figure 7 depicts an alternative arrangement for connection of the balance mass to the base frame.

Figure 8 depicts an other alternative arrangement for connection of the balance mass to the base frame.

Figure 9 schematically depicts a Balance Mass that is coupled in 3 degrees of freedom in the horizontal plane.

In the Figures, corresponding reference symbols indicate corresponding parts.

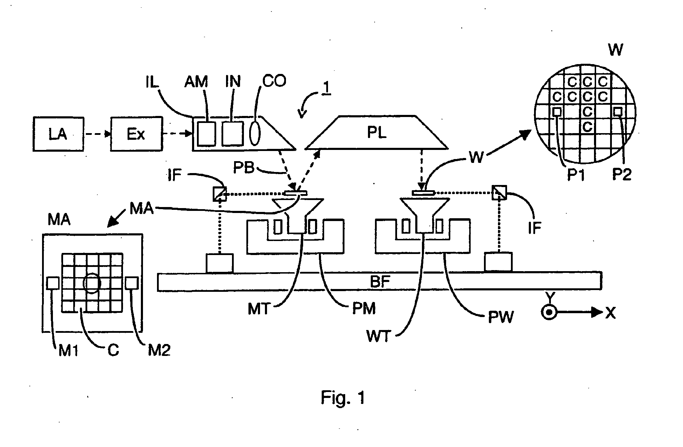

Figure 1 schematically depicts the relevant parts of a lithographic projection apparatus. The apparatus comprises:

a radiation system Ex, IL, for supplying a projection beam PB of radiation (e.g. I-line, UY, EUY radiation, Electron Beam etc.), which in this particular case also comprises a radiation source LA;

a first object table (mask table) MT provided with a mask holder for holding a mask MA (e.g. a reticle), and connected to first positioning means PM for accurately positioning the mask with respect to item PL;

a second object table (substrate table) WT provided with a substrate holder for holding a substrate W (e.g. a resist-coated silicon wafer), and connected to second substrate table positioning means PW for accurately positioning the substrate with respect to item PL;

a projection system ("lens") PL (e.g. a mirror system) for imaging an irradiated portion of the mask MA onto a target portion C (e.g. comprising one or more dies) of the substrate W.

As here depicted, the apparatus is of a reflective type (i.e. has a reflective mask). However, in general, it may also be of a transmission type, for example (with a transmissive mask). Alternatively, the apparatus may employ another kind of patterning means, such as a programmable mirror array of a type as referred to above.

The source LA (e.g. a laser-produced discharge plasma source) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (e.g. with the aid of suitable directing mirrors); this latter scenario is often the case when the source LA is an excimer laser. The current invention and Claims encompass both of these scenarios.

The beam PB subsequently intercepts the mask MA, which is held on a mask table MT. Having traversed the mask MA, the beam PB passes through the lens PL, which focuses the beam PB onto a target portion C of the substrate W. With the aid of the second positioning means (and interferometric measuring means IF), the substrate table WT can be moved accurately, e.g. so as to position different target portions C in the path of the beam PB. Similarly, the first positioning means can be used to accurately position the mask MA with respect to the path of the beam PB, e.g. after mechanical retrieval of the mask MA from a mask library, or during a scan. In general, movement of the object tables MT, WT will be realized with the aid of a long stroke module (course positioning) and a short-stroke module (fine positioning), which are not explicitly depicted in Figure 1. It is noted that generally, the long stroke module enables long stroke movements of the substrate table substantially in a plane, while the long stroke module of the mask table enables long stroke movements substantially in one direction. However, in the case of a wafer stepper (as opposed to a step-and-scan apparatus) the mask table MT may just be connected to a short stroke actuator enabling short stroke movements in six degrees of freedom, or may be fixed.

The depicted apparatus can be used in two different modes:

1. In step mode, the mask table MT is kept essentially stationary, and an entire mask image is projected in one go (i.e. a single "flash") onto a target portion C. The substrate table WT is then shifted in the x and/or y directions so that a different target portion C can be irradiated by the beam PB;

2. In scan mode, essentially the same scenario applies, except that a given target portion C is not exposed in a single "flash". Instead, the mask table MT is movable in a given direction (the so-called "scan direction", e.g. the y direction) with a speed v, so that the projection beam PB is caused to scan over a mask image; concurrently, the substrate table WT is simultaneously moved in the same or opposite direction at a speed V = Mv, in which M is the magnification of the lens PL (typically, M = 1/4 or 1/5). In this manner, a relatively large target portion C can be exposed, without having to compromise on resolution.

The invention will be described with reference to the substrate table WT. However, the invention is equally applicable to the mask table MT.

As can be seen from Figure 1 a typical Lithographic apparatus comprises a base frame BF on which the various components are supported.

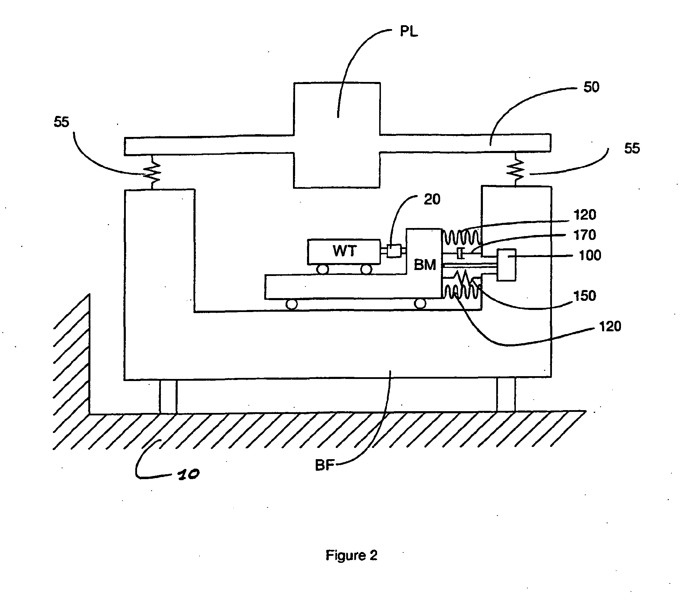

As an example, the mounting of the various components to the base frame is illustrated schematically in Figure 2. This figure shows the base frame BF which is preferably stiffly connected to the ground 10. The projection system PL is isolated from vibrations of the base frame BF by being mounted on a metrology frame 50 which is compliantly connected to the base frame BF with a soft suspension system 55 of an active vibration isolation system (AVIS). The Wafer Table is driven by an actuator (20) and the reaction force is set on the Balance Mass (BM). An elastic coupling 150 is connected between the balance mass and the Base Frame. The stiffness of the elastic coupling 150 is chosen such that the balance mass is monnted on the Base Frame BF with a suispension eigenfrequency in the translational (horizontal) plane of between 0.3 and 10 Hz preferably 1 to 6 Hz. A suitable suspension eigenfrequency is about 3 Hz.

The suspension eigenfrequency $f_0$ can be calculated according to equation (1):

$$f_0 = \frac{1}{2\pi}\sqrt{\frac{k_{spring}}{m_{BM}}}, \qquad (1)$$

wherein $k_{spring}$ is the stiffness of the spring of the elastic coupling 150 and $m_{BM}$ is the mass of the balance mass BM. Arranging for the suspension eigenfrequency of the balance mass to be in the range of 0.3 to 10 Hz ensures that a large but low frequency force dump into the base frame from the balance mass is allowed in both directions in the translational horizontal plane (forces of up to about 5000 N at a frequency of less than 3 Hz). In this example, in parallel with the elastic coupling 150, a damper 170 is placed and a Balance Mass actuator 100. The elastic coupling 150, the damper 170 and the Balance Mass actuator may optionally be enclosed by a bellows 120. In this way, the elastic coupling, the damper and the balance mass actuator are sealed off from the compartment wherein the substrate table WT and the Balance Mass are located. The use of bellows may impose less stringent conditions on the elastic coupling, the damper and the balance mass actuator with respect to contamination or outgassing properties, etc.,

The balance mass actuator 100 is used to correct the position of the balance mass which can have a tendency to drift from the correct position. This drift, which can be thought of as hysterisis, can be as a result of friction between the Base Frame BF and the balance mass BM, for example. The correction is applied as a closed loop control by having a controller which controls the balance mass actuator 100 and periodically (for example every millisecond) applies a force, if necessary, to center the balance mass BM substantially to prevent drift of the balance mass resulting from repetitive motions of the substrate table.

The actuator 100 may also be used to damp movement of the balance mass BM to avoid windup i.e. resonance of the balance mass BM. Alternatively, this function may be performed by the separate mechanical passive damper 170. Whatever form of damping is used, the relative damping coefficient, b, is preferably between 0.5 and 1.0 and more preferably between 0.65 to 0.75. If the balance mass actuator 100 is used, it may be used as an active damper, the damping coefficient, b, being varied as a function of frequency. For example, a damping coefficient of b = 0.7 may be used up to a threshold frequency (of, for example, in the region of 0.3 to 20 Hz) after which the damping coefficient reduces such that at a frequency of infinity, the damping coefficient is zero. In this way, the force transfer from Balance Mass to Base Frame at high frequencies is less than that for the case where the damping coefficient is constant. This damping also reduces the amplitude of the force transfer from Balance Mass to base frame for frequencies of movement of the substrate table WT close to the suspension eigenfrequency of the balance mass BM.

The balance mass actuator 100 may also be used to smooth the force profile transmitted at low frequencies to the base frame using a filtered feed forward program. This is done by passing the expected reaction force of the balance mass BM on the Base Frame BF through a low pass filter and applying a force through the balance mass actuator 100 to the balance mass BM which smoothes out the sharp changes in reaction force.

High frequency disturbances are not passed to the Base Frame in any case.

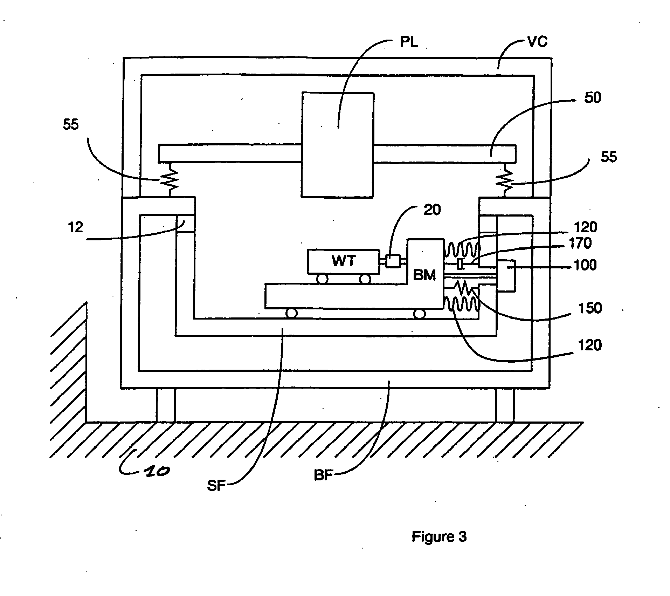

Figure 3 shows an alternative arrangement of the various components supported by the base frame BF for use in vacuum applications. In this example, the substrate table WT is positioned on a substrate table support frame SF (which is stiffly connected to the base frame BF) via connecting means 12. The Wafer Table is driven by an actuator (20) and the reaction force is set on the Balance Mass (BM). An elastic coupling 150 parallel with a Balance Mass actuator 100 and a damper 170 are connected between the Balance Mass and the substrate table support frame. In this arrangement, the projection system PL, balance mass BM and substrate table WT are enclosed by a vacuum chamber VC that is stiffly connected to the base frame BM.

Both the substrate table WT and balance mass BM are mounted such that translational movement in the horizontal plane parallel to the surface of the substrate table support frame SF is substantially frictionless. This can be achieved, for example, by suspending the substrate table WT from the balance mass and providing the balance mass with air bearings or providing both the substrate table and the balance mass with air bearings such that their weight can be supported by the substrate table support frame SF. The balance mass may also be suspended on elastic mechanical or pneumatic springs.

On actuation of the positioning actuator 20 to generate a reaction force, the substrate table WT and balance mass BM will translate in opposite directions.

The balance mass BM is elastically coupled to the substrate table support frame SF and thereby to the base frame BF with an elastic spring coupling 150. The stiffness of the elastic coupling 150 is chosen such that the balance mass is mounted on the wafer stage support frame SF with a suspension eigenfrequency in the translational (horizontal) plane of between 0.3 and 10 Hz preferably 1 to 6 Hz. A suitable suspension eigenfrequency is about 3 Hz.

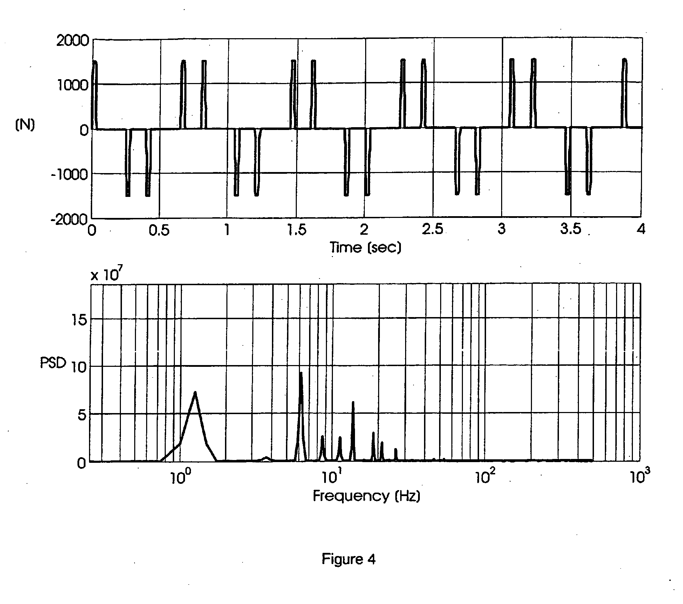

Figure 4 shows the acceleration and deceleration forces that typically occur during the scanning process. Acceleration and deceleration forces are shown both in the time domain and in the frequency domain. In this example, In this example the maximal acceleration force is about 1500 [N]. Also the Power Spectrum or the energy per frequency band is shown. Typically the acceleration profile Power Spectrum shows large forces at frequencies below 20 [Hz]. Above this frequency the remaining energy is very small.

Applying a suspension eigenfrequency in the range of 0.3 to 10 Hz for the Balance Mass, short stroke translational movements of the substrate table WT, which occur at frequency of about 10-15 Hz and above, are hardly transferred to the base frame as the Balance Mass acts here in a conventional free mass manner. However, for long stroke translational movements of the substrate table WT, which occur at a low frequency of below about 15 Hz, at least a part of the reaction force is transferred to the substrate table support frame SF and thereby to the base frame BF. Thus, the displacement required of the balance mass for low frequency movements is reduced as a portion of the reaction force (between 50 and 100%) is exerted on the substrate table support frame SF via the elastic coupling 150. It has been found that such large but low frequency force dumps in the horizontal translational direction can be applied to the base frame BF (typically about 1000-5000 N at frequencies of less than 3 Hz) without deleterious effects to the performance of the apparatus.

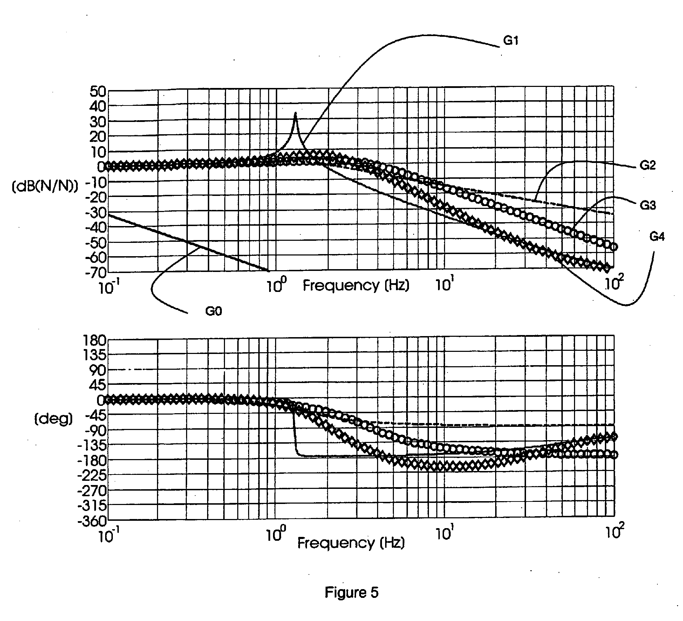

Figure 5 shows the Bode plots of transfer of Balance Mass forces to the Base Frame for a number of arrangements. This figure shows the Balance Mass force to Base Frame force ratio (in dB) vs. the frequency [Hz]. As a reference, the characteristic of a freely mounted Balance Mass (i.e a Newton Balance Mass) is shown as graph G0. A perfect Balance Mass that operates according to Newtons 'action = reaction' Law, will absorb all energy and thus cannot transmit forces to the Base Frame. A less perfect Newton Balance Mass will partly transmit a very small amount of force with low frequencies. A Newton Balance Mass has the disadvantage that the motion or excursion is equal to the mass ratio of Balance Mass and Substrate Table. If an elastic coupling is connected between the Balance Mass and the Base Frame, the Balance Mass excursion can be much reduced. The effect however is that low frequency forces are directly transmitted (to the base Frame) and that at the resonance frequency the Base Frame force can be much higher than the Balance Mass force, as is shown in graph G1. Above the resonance frequency, the undamped Balance Mass again reduces the force dump into the Base Frame and forms a mechanical filter with a roll-off of -40 [dB/dec]. The amplification at the resonance frequency is reduced by applying a passive damper in parallel with the elastic coupling between the Balance Mass and the Base Frame as shown in graph G3. However the mechanical filter of this Damped Balance Mass then only has a roll-off of -20 [dB/dec].

When the damping element is formed by a damper in series with a spring, this combined system of elastic coupling and spring-damper system, also referred to as the KDK-sytem, again has a roll-off of -40 [dB/dec], although the filtering starts at a higher frequency. As is shown in graph G3, the performance of this KDK-system Balance Mass is superior to the Damped Balance Mass shown in G2.

In an other arrangement, a control loop formed by an actuator between the Balance Mass and Base Frame and a position sensor that measures the position of the Balance Mass relative to the Base Frame is applied. The controller can be adjusted in such a way that both the damping of the resonance frequency is obtained and the steep -40 [dB] roll off is maintained, see graph G4.

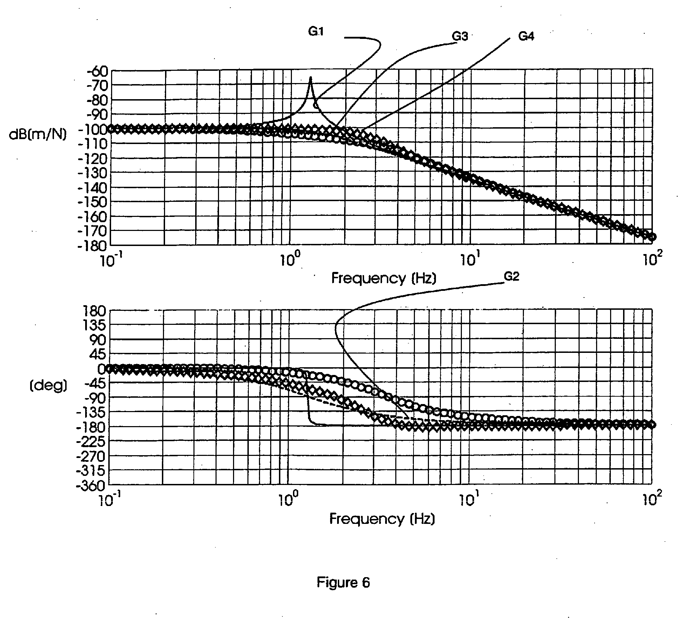

Figure 6 depicts the Bode plots of the transfer of the Balance Mass motion to the Reaction Force is plotted. At low frequencies, the Balance Mass motion as function of the input force is proportional to the inverse of the stiffness of the elastic coupling. So a stiffness of 1e5 [N/m] between Balance Mass and Base Frame will result in 1e-5 [m] displacement per 1 [N] input force (so the transfer is 1e-5 [m/N] or -100 dB). For 1500 [N] the displacement is about 15 mm. If the stiffness is increased, the motion is reduced by the same factor, but also the frequency band for the output forces is increased (see figure 6 and eq. 1). So a soft elastic coupling comes with soft forces (strong Balance Mass filtering) but also a large excursion. A stiff elastic coupling has hard forces (poor filtering) but a small excursion. Somehow a suitable compromise between Balance Mass excursion and Force Filtering performance can be found. The use of an elastic coupling that has a non-linear characteristic may be applied to accommodate this compromise. Both linear and non-linear springs-type elements may be applied to realize this. These elements can be arranged between balance mass and base frame in such manner that the stiffness progressively increases when the balance mass is displaced from its neutral position.

Near the resonance frequency, the displacement will be amplified if no damping is present (the amplification shown in figure 6 is approx. 100 x !). In order to avoid this, a damping element should be combined with the elastic coupling. Graph G1 in figure 6 shows the characteristics of the undamped system, G2 shows the characteristics of the damped system, G3 shows the characteristics of the KDK-system and G4 shows the characteristics of the elastic coupling combined with the Balance Mass actuator. In the damped systems (G2,G3,G4), the amplification occurring in the undamped system at the resonance frequency is attenuated. For high frequencies all systems have a -40 dB/dec roll off, so forces with very high frequency can only generate small Balance Mass displacements.

In a vacuum application, the balance mass BM is connected to the wall of the vacuum chamber VC by metal bellows 120 which may be manufactured from welding a curved plate ore buckling a wide pipe with thin walls. The bellows allow the elastic coupling 150 and the actuator 100 to be placed outside of the vacuum chamber VC such that their design requirements are less stringent as they do not need to be vacuum compliant (for example meet out-gassing criteria). Furthermore, utilities can be provided to the balance mass BM through the bellows 120 via pipes or cables. The use of bellows 120 is possible because of the small stroke which the balance mass BM undergoes during positioning of the substrate table WT. The bellows may form at least part of the elastic coupling of the balance mass BM to the base frame.

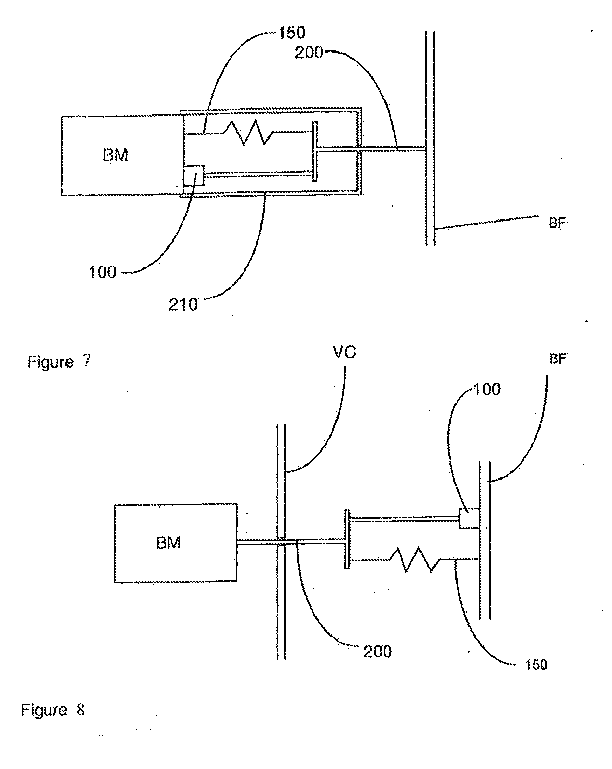

Figure 7 shows an alternative layout for the connection of the balance mass BM to the base frame which, in this arrangement, is part of the vacuum chamber wall VC. The elastic coupling 150 and balance mass actuator 100 are housed in the substrate table vacuum chamber within a secondary vacuum chamber 210 which may conveniently be at higher pressure than the substrate table vacuum chamber VC. A connection member 200 connects the elastic coupling 150 and balance mass actuator 100 to the substrate table vacuum chamber wall Vc. A seal or bellow is required between the secondary vacuum chamber 200 and the connection chamber. In alternative illustrated in Figure 8, the connection member 200 connects the balance mass BM to the elastic coupling 150 and the balance mass actuator 100 which are directly connected to the base frame BF. The substrate table vacuum chamber VC is separate from the base frame in this arrangement such that the balance mass actuator BM does not need to be vacuum compliant as it is positioned outside of the vacuum. A seal is required between the substrate table vacuum chamber VC and the connection member 200.

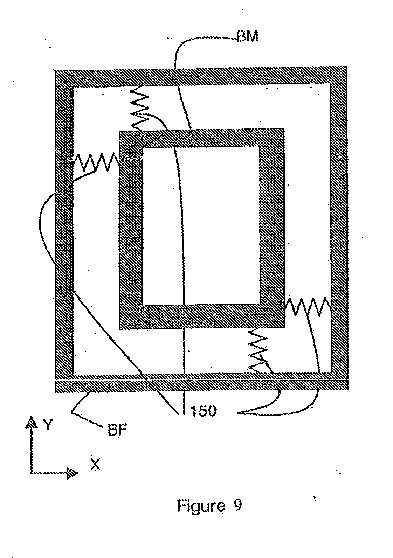

In an embodiment of the invention, the balance mass BM has 3 degrees of freedom in the horizontal plane. The coupling as described by the present invention between balance mass and support frame is applicable in all degrees of freedom in which the substrate table or support structure have movements. The elastic coupling between balance ass and support frame may have different properties for the different degrees of freedom. According to the invention, the elastic coupling is combined with a balance mass actuator and may further the combined with a spring-damper system having different properties for the different degrees of freedom. As an example, Figure 9 shows a top view of a possible arrangement wherein the elastic couplings 150 are springs between a balance mass BM and a base frame BF. It should be clear that the depicted elastic coupling is combined with a Balance Mass actuator. It should also be noted that in this arrangement the Balance Mass is coupled in 3 degrees of freedom (X,Y and Rz) although only springs in X and Y direction are applied. This method for defining the elastic coupling in different degrees of freedom can also be applied for more than 3 degrees of freedom.

Whilst specific embodiments of the invention have been described above, it will be appreciated that the invention may be practiced otherwise than as described. The description is not intended to limit the invention.

## Claims

1. A lithographic projection apparatus (1) comprising:

    - a radiation system (LA, EX, IL) for providing a projection beam (PB) of radiation;
    - a support structure (MT) for supporting patterning means (MA), the patterning means serving to pattern the projection beam according to a desired pattern;
    - a substrate table (WT) for holding a substrate (W);
    - a projection system (PL) for projecting the patterned beam onto a target portion of the substrate;
    - a base frame (BF);
    - a balance mass (BM) with 3 degrees of freedom, the 3 degrees of freedom being in the horizontal plane; and
    - a positioning actuator (20) connected between said substrate table (WT) or said support structure (MT) and said balance mass (BM) for generating a reaction force between said balance mass (BM) and said substrate table (WT) or said support structure (MT) thereby to position said substrate table (WT) or said support structure (MT) relative to said projection system (PL) in the 3 degrees of freedom in the horizontal plane, wherein said balance mass (BM) is coupled to said base frame (BF) in the 3 degrees of freedom in the horizontal plane via an elastic coupling (150) so that said balance mass (BM) has a suspension eigenfrequency of between 0.3 and 10 Hz such that a portion of said reaction force is exerted on said base frame (BF), and **characterized by** further comprising a balance mass actuator (100) for controlling the position of said balance mass (BM), and in that the balance mass (BM) is supported by the base frame (BF) via a bearing.

2. An apparatus according to claim 1, constructed and arranged such that on movement during positioning of said substrate table or said support structure (MT) the position of the combined center of gravity of said substrate table (WT) or said support structure (MT) and said balance mass (BM) relative to said base frame (BF) also moves.

3. An apparatus according to claim 1 or 2, wherein said balance mass actuator (100) is positioned in parallel with said elastic coupling (150), wherein the balance mass (BM) is also coupled to said base frame (BF) via the balance mass actuator (100).

4. An apparatus according to claim 1, 2 or 3, wherein, in use, vibration of said balance mass (BM) due to said elastic coupling (150) is actively damped by said balance mass actuator (100).

5. An apparatus according to any one of the preceding claims, wherein, in use, vibration of said balance mass (BM) generated due to said elastic coupling (150) is damped with said balance mass actuator (100) with a damping coefficient, b, of between 0.5 and 1.0, preferably 0.65 to 0.75.

6. An apparatus according to claim 5 wherein said balance mass actuator (100) is positioned in parallel with said elastic coupling (150), wherein the balance mass (BM) is also coupled to said base frame (BF) via said balance mass actuator (100).

7. An apparatus according to any one of claims 4 to 6, wherein said balance mass (BM) is damped with a damping coefficient, b, which is varied as a function of frequency.

8. An apparatus according to any one of the preceding claims, further comprising a controller for controlling said balance mass actuator (100) and for periodically applying a position control loop substantially to prevent drift of said balance mass (BM) due to repetitive motions of said substrate table (WT) or said support structure (MT).

9. An apparatus according to any one of the preceding claims, wherein between 50 and 100% of said reaction force with a frequency below 3 to 10Hz is exerted by said elastic coupling (150) on said base frame (BF).

10. An apparatus according to any one of the preceding claims, wherein a bellows (120) extends between said balance mass (BM) and said base frame (BF).

11. An apparatus according to any one of the preceding claims, further comprising a vacuum chamber (VC) containing said substrate table (WT) or said support structure (MT) and said balance mass (BM).

12. An apparatus according to claim 11, wherein said base frame (BF) forms part of the wall portions of said vacuum chamber (VC) and wherein a bellows (120) extends between said balance mass (BM) and said wall portions.

13. An apparatus according to claim 10 or 12, wherein said bellows (120) forms at least part of said elastic coupling (150).

14. An apparatus according to claim 12 or 13, wherein said balance mass actuator (100) is connected with said balance mass (BM) through said bellows (120).

15. An apparatus according to any of the preceding claims, **characterized in that** the stiffness of the elastic coupling (150) is a function of the relative position of the balance mass (BM) with respect to the base frame (BF).

16. An apparatus according to any one of the preceding claims, **characterized in that** the lithographic apparatus further comprises a feed forward controller for controlling the balance mass actuator (100).

17. A device manufacturing method comprising the steps of:

- providing a substrate (W) that is at least partially covered by a layer of radiation-sensitive material on a substrate table (WT) positioned on a base frame (BF);
- providing a projection beam (PB) of radiation using a radiation system (LA, EX, IL);
- using patterning means (MA) supported on a support structure (MT) to endow the projection beam (PB) with a pattern in its cross-section;
- projecting the patterned beam of radiation (PB) onto a target portion of the layer of radiation-sensitive material;
- providing a balance mass (BM) with 3 degrees of freedom, the 3 degrees of freedom being in the horizontal plane;
- moving said substrate table (WT) or said support structure (MT) relative to said base frame (BF) in the 3 degrees of freedom in the horizontal plane by generating a reaction force between said substrate table (WT) or said support structure (MT) and the balance mass (BM),
- transmitting part of said reaction force to said base frame (BF) through an elastic coupling (150) which couples said balance mass (BM) to said base frame (BF) in the 3 degrees of freedom in the horizontal plane with a suspension eigenfrequency of between 0. 3 and 10 Hz,

**characterized by** controlling the position of the balance mass (BM) by using a balance mass actuator (100) and by supporting the balance mass (BM) on the base frame (BF) via a bearing.

**Patentansprüche**

1. Ein lithographisches Projektionsgerät (1), das Folgendes beinhaltet:

- ein Strahlungssystem (LA, EX, IL) zum Bereitstellen eines Projektionsstrahls (PB) aus Strahlung;
- eine Stützstruktur (MT) zum Stützen eines Musteraufbringungsmittels (MA), wobei das Musteraufbringungsmittel dazu dient, den Projektionsstrahl gemäß einem gewünschten Muster zu mustern;
- einen Substrattisch (WT) zum Halten eines Substrats (W);
- ein Projektionssystem (PL) zum Projizieren des gemusterten Strahls auf einen Zielabschnitt des Substrats;
- einen Basisrahmen (BF);
- eine Ausgleichsmasse (BM) mit 3 Freiheitsgraden, wobei sich die 3 Freiheitsgrade in der horizontalen Ebene befinden; und
- einen Positionierungsaktor (20), der mit dem Substrattisch (WT) oder der Stützstruktur (MT) und der Ausgleichsmasse (BM) verbunden ist, um zwischen der Ausgleichsmasse (BM) und dem Substrattisch (WT) oder der Stützstruktur (MT) eine Auflagerkraft zu erzeugen, um dadurch den Substrattisch (WT) oder die Stützstruktur (MT) relativ zu dem Projektionssystem (PL) in den 3 Freiheitsgraden in der horizontalen Ebene zu positionieren, wobei die Ausgleichsmasse (BM) in den 3 Freiheitsgraden in der horizontalen Ebene über eine elastische Kupplung (150) an den Basisrahmen (BF) gekuppelt ist, so dass die Ausgleichsmasse (BM) eine Aufhängungseigenfrequenz von zwischen 0,3 und 10 Hz aufweist, so dass ein Anteil der Auflagerkraft auf den Basisrahmen (BF) ausgeübt wird, und **dadurch gekennzeichnet, dass** ferner ein Ausgleichsmassenaktor (100) zum Steuern der Position der Ausgleichsmasse (BM) beinhaltet ist, und dass die Ausgleichsmasse (BM) über ein Lager von dem Basisrahmen (BF) gestützt wird.

2. Gerät gemäß Anspruch 1, das so konstruiert und eingerichtet ist, dass sich die Position des kombinierten Schwerpunktes des Substrattisches (WT) oder der Stützstruktur (MT) und der Ausgleichsmasse (BM) relativ zu dem Basisrahmen (BF) bei Bewegung während der Positionierung des Substrattisches oder der Stützstruktur (MT) ebenfalls bewegt.

3. Gerät gemäß Anspruch 1 oder 2, wobei der Ausgleichsmassenaktor (100) parallel zu der elastischen Kupplung (150) positioniert ist, wobei die Ausgleichsmasse (BM) auch über den Ausgleichsmassenaktor (100) an den Basisrahmen (BF) gekuppelt ist.

4. Gerät gemäß Anspruch 1, 2 oder 3, wobei die Vibration der Ausgleichsmasse (BM) aufgrund der elastischen Kupplung (150) bei Gebrauch von dem Ausgleichsmassenaktor (100) aktiv gedämpft wird.

5. Gerät gemäß einem der vorhergehenden Ansprüche, wobei die aufgrund der elastischen Kupplung (150) erzeugte Vibration der Ausgleichsmasse (BM) mit dem Ausgleichsmassenaktor (100) mit einem Dämpfungskoeffizienten b von zwischen 0,5 und 1,0, vorzugsweise 0,65 bis 0,75, gedämpft wird.

6. Gerät gemäß Anspruch 5, wobei der Ausgleichsmassenaktor (100) parallel zu der elastischen Kupplung (150) positioniert ist, wobei die Ausgleichsmasse (BM) auch über den Ausgleichsmassenaktor (100) an den Basisrahmen (BF) gekuppelt ist.

7. Gerät gemäß einem der Ansprüche 4 bis 6, wobei die Ausgleichsmasse (BM) mit einem Dämpfungskoeffizienten b, der als eine Funktion der Frequenz variiert wird, gedämpft wird.

8. Gerät gemäß einem der vorhergehenden Ansprüche, das ferner eine Steuerungseinheit zum Steuern des Ausgleichsmassenaktors (100) und zum periodischen Anwenden einer Positionsregelschleife beinhaltet, um eine Drift der Ausgleichsmasse (BM) aufgrund wiederholter Bewegungen des Substrattisches (WT) oder der Stützstruktur (MT) im Wesentlichen zu verhindern.

9. Gerät gemäß einem der vorhergehenden Ansprüche, wobei zwischen 50 und 100 % der Auflagerkraft mit einer Frequenz unter 3 bis 10 Hz von der elastischen Kupplung (150) auf den Basisrahmen (BF) ausgeübt wird.

10. Gerät gemäß einem der vorhergehenden Ansprüche, wobei sich zwischen der Ausgleichsmasse (BM) und dem Basisrahmen (BF) ein Balg (120) erstreckt.

11. Gerät gemäß einem der vorhergehenden Ansprüche, das ferner eine Vakuumkammer (VC) beinhaltet, die den Substrattisch (WT) oder die Stützstruktur (MT) und die Ausgleichsmasse (BM) enthält.

12. Gerät gemäß Anspruch 11, wobei der Basisrahmen (BF) einen Teil der Wandabschnitte der Vakuumkammer (VC) bildet und wobei sich zwischen der Ausgleichsmasse (BM) und den Wandabschnitten ein Balg (120) erstreckt.

13. Gerät gemäß Anspruch 10 oder 12, wobei der Balg (120) mindestens einen Teil der elastischen Kupplung (150) bildet.

14. Gerät gemäß Anspruch 12 oder 13, wobei der Ausgleichsmassenaktor (100) durch den Balg (120) mit der Ausgleichsmasse (BM) verbunden ist.

15. Gerät gemäß einem der vorhergehenden Ansprüche, **dadurch gekennzeichnet, dass** die Steifheit der elastischen Kupplung (150) eine Funktion der relativen Position der Ausgleichsmasse (BM) in Bezug auf den Basisrahmen (BF) ist.

16. Gerät gemäß einem der vorhergehenden Ansprüche, **dadurch gekennzeichnet, dass** das lithographische Gerät ferner eine Optimalwertsteuerungseinheit zum Steuern des Ausgleichsmassenaktors (100) beinhaltet.

17. Ein Verfahren zum Herstellen einer Vorrichtung, das die folgenden Schritte beinhaltet:

    - Bereitstellen eines Substrats (W), das mindestens teilweise von einer Schicht aus strahlungsempfindlichem Material bedeckt ist, auf einem Substrattisch (WT), der auf einem Basisrahmen (BF) positioniert ist;
- Bereitstellen eines Projektionsstrahls (PB) aus Strahlung unter Verwendung eines Strahlungssystems (LA, EX, IL);
- Verwenden eines Musteraufbringungsmittels (MA), das auf einer Stützstruktur (MT) gestützt wird, um den Projektionsstrahl (PB) in seinem Querschnitt mit einem Muster zu versehen;
- Projizieren des gemusterten Strahls aus Strahlung (PB) auf einen Zielabschnitt der Schicht aus strahlungsempfindlichem Material;
- Bereitstellen einer Ausgleichsmasse (BM) mit 3 Freiheitsgraden, wobei sich die 3 Freiheitsgrade in der horizontalen Ebene befinden;
- Bewegen des Substrattisches (WT) oder der Stützstruktur (MT) relativ zu dem Basisrahmen (BF) in den 3 Freiheitsgraden in der horizontalen Ebene, indem zwischen dem Substrattisch (WT) oder der Stützstruktur (MT) und der Ausgleichsmasse (BM) eine Auflagerkraft erzeugt wird,
- Übertragen eines Teils der Auflagerkraft auf den Basisrahmen (BF) durch eine elastische Kupplung (150), die die Ausgleichsmasse (BM) an den Basisrahmen (BF) in den 3 Freiheitsgraden in der horizontalen Ebene mit einer Aufhängungseigenfrequenz von zwischen 0,3 und 10 Hz kuppelt,

**dadurch gekennzeichnet, dass** die Position der Ausgleichsmasse (BM) gesteuert wird, indem ein Ausgleichsmassenaktor (100) verwendet wird, und die Ausgleichsmasse (BM) über ein Lager auf dem Basisrahmen (BF) gestützt wird.

**Revendications**

1. Un appareil de projection lithographique (1) comprenant :

   - un système de rayonnement (LA, EX, IL) pour fournir un faisceau de projection (PB) de rayonnement ;
   - une structure formant support (MT) pour supporter un moyen pour conformer selon un motif (MA), le moyen pour conformer selon un motif servant à conformer le faisceau de projection selon un motif souhaité ;
   - une table porte-substrat (WT) pour porter un substrat (W) ;
   - un système de projection (PL) pour projeter le faisceau à motif sur une portion cible du substrat ;
   - un cadre de base (BF) ;
   - une masse d'équilibrage (BM) avec 3 degrés de liberté, les 3 degrés de liberté étant dans le plan horizontal ; et
- un actionneur de positionnement (20) raccordé entre ladite table porte-substrat (WT) ou ladite structure formant support (MT) et ladite masse d'équilibrage (BM) pour générer une force de réaction entre ladite masse d'équilibrage (BM) et ladite table porte-substrat (WT) ou ladite structure formant support (MT) pour positionner de ce fait ladite table porte-substrat (WT) ou ladite structure formant support (MT) relativement audit système de projection (PL) dans les 3 degrés de liberté dans le plan horizontal, ladite masse d'équilibrage (BM) étant couplée audit cadre de base (BF) dans les 3 degrés de liberté dans le plan horizontal via un accouplement élastique (150) afin que ladite masse d'équilibrage (BM) ait une fréquence propre de suspension comprise entre 0,3 et 10 Hz de telle sorte qu'une portion de ladite force de réaction soit exercée sur ledit cadre de base (BF), et **caractérisé par** le fait de comprendre en outre un actionneur de masse d'équilibrage (100) pour contrôler la position de ladite masse d'équilibrage (BM), et en ce que la masse d'équilibrage (BM) est supportée par le cadre de base (BF) via un palier.

2. Un appareil selon la revendication 1, construit et agencé de telle sorte que lors d'un déplacement pendant le positionnement de ladite table porte-substrat ou de ladite structure formant support (MT) la position du centre de gravité combiné de ladite table porte-substrat (WT) ou de ladite structure formant support (MT) et de ladite masse d'équilibrage (BM) relativement audit cadre de base (BF) se déplace également.

3. Un appareil selon la revendication 1 ou la revendication 2, dans lequel ledit actionneur de masse d'équilibrage (100) est positionné en parallèle avec ledit accouplement élastique (150), la masse d'équilibrage (BM) étant également couplée audit cadre de base (BF) via l'actionneur de masse d'équilibrage (100).

4. Un appareil selon la revendication 1, la revendication 2 ou la revendication 3, dans lequel, lors de l'utilisation, une vibration de ladite masse d'équilibrage (BM) causée par ledit accouplement élastique (150) est activement amortie par ledit actionneur de masse d'équilibrage (100).

5. Un appareil selon l'une quelconque des revendications précédentes, dans lequel, lors de l'utilisation, une vibration de ladite masse d'équilibrage (BM) générée à cause dudit accouplement élastique (150) est amortie avec ledit actionneur de masse d'équilibrage (100) avec un coefficient d'amortissement, b, compris entre 0,5 et 1,0, de préférence entre 0,65 et 0,75.

6. Un appareil selon la revendication 5 dans lequel ledit actionneur de masse d'équilibrage (100) est positionné en parallèle avec ledit accouplement élastique (150), la masse d'équilibrage (BM) étant également couplée audit cadre de base (BF) via ledit actionneur de masse d'équilibrage (100).

7. Un appareil selon l'une quelconque des revendications 4 à 6, dans lequel ladite masse d'équilibrage (BM) est amortie avec un coefficient d'amortissement, b, qui est amené à varier en fonction de la fréquence.

8. Un appareil selon l'une quelconque des revendications précédentes, comprenant en outre un organe de commande pour commander ledit actionneur de masse d'équilibrage (100) et pour appliquer périodiquement une boucle de commande de position afin d'empêcher substantiellement une dérive de ladite masse d'équilibrage (BM) causée par des mouvements répétitifs de ladite table porte-substrat (WT) ou de ladite structure formant support (MT).

9. Un appareil selon l'une quelconque des revendications précédentes, dans lequel entre 50 et 100 % de ladite force de réaction avec une fréquence au-dessous de 3 à 10 Hz est exercée par ledit accouplement élastique (150) sur ledit cadre de base (BF).

10. Un appareil selon l'une quelconque des revendications précédentes, dans lequel un soufflet (120) s'étend entre ladite masse d'équilibrage (BM) et ledit cadre de base (BF).

11. Un appareil selon l'une quelconque des revendications précédentes, comprenant en outre une chambre à vide (VC) contenant ladite table porte-substrat (WT) ou ladite structure formant support (MT) et ladite masse d'équilibrage (BM).

12. Un appareil selon la revendication 11, dans lequel ledit cadre de base (BF) forme une partie des portions de paroi de ladite chambre à vide (VC) et dans lequel un soufflet (120) s'étend entre ladite masse d'équilibrage (BM) et lesdites portions de paroi.

13. Un appareil selon la revendication 10 ou la revendication 12, dans lequel ledit soufflet (120) forme au moins une partie dudit accouplement élastique (150).

14. Un appareil selon la revendication 12 ou la revendication 13, dans lequel ledit actionneur de masse d'équilibrage (100) est raccordé à ladite masse d'équilibrage (BM) par l'intermédiaire dudit soufflet (120).

15. Un appareil selon n'importe lesquelles des revendications précédentes, **caractérisé en ce que** la raideur de l'accouplement élastique (150) est fonction de la position relative de la masse d'équilibrage (BM) par rapport au cadre de base (BF).

16. Un appareil selon l'une quelconque des revendications précédentes, **caractérisé en ce que** l'appareil lithographique comprend en outre un organe de commande par anticipation pour commander l'actionneur de masse d'équilibrage (100)

17. Un procédé de fabrication de dispositif comprenant les étapes consistant à :

- fournir un substrat (W) qui est au moins partiellement recouvert d'une couche de matériau sensible au rayonnement sur une table porte-substrat (WT) positionnée sur un cadre de base (BF) ;
- fournir un faisceau de projection (PB) de rayonnement à l'aide d'un système de rayonnement (LA, EX, IL) ;
- utiliser un moyen pour conformer selon un motif (MA) supporté sur une structure formant support (MT) afin de doter le faisceau de projection (PB) d'un motif dans sa coupe transversale ;
- projeter le faisceau de rayonnement à motif (PB) sur une portion cible de la couche de matériau sensible au rayonnement ;
- fournir une masse d'équilibrage (BM) avec 3 degrés de liberté, les 3 degrés de liberté étant dans le plan horizontal ;
- déplacer ladite table porte-substrat (WT) ou ladite structure formant support (MT) relativement audit cadre de base (BF) dans les 3 degrés de liberté dans le plan horizontal en générant une force de réaction entre ladite table porte-substrat (WT) ou ladite structure formant support (MT) et la masse d'équilibrage (BM),
- transmettre une partie de ladite force de réaction audit cadre de base (BF) par l'intermédiaire d'un accouplement élastique (150) qui couple ladite masse d'équilibrage (BM) audit cadre de base (BF) dans les 3 degrés de liberté dans le plan horizontal avec une fréquence propre de suspension comprise entre 0,3 et 10 Hz,

**caractérisé par** le fait de commander la position de la masse d'équilibrage (BM) à l'aide d'un actionneur de masse d'équilibrage (100) et par le fait de supporter la masse d'équilibrage (BM) sur le cadre de base (BF) via un palier.

EP 1 369 745 B1

Fig. 1

14

Figure 2

Figure 3

Figure 4

Figure 5

18

Figure 6

Figure 7

Figure 8

Figure 9

**REFERENCES CITED IN THE DESCRIPTION**

**Patent documents cited in the description**

- US 5296891 A
- US 5523193 A
- WO 9838597 A
- WO 9833096 A
- US 5229872 A
- US 6046792 A
- US 5969441 A
- WO 9840791 A
- US 6262796 B
- US 20020012108 A
- EP 0917004 A2
- US 20010006762 A
- EP 1111470 A2

**Non-patent literature cited in the description**

- Microchip Fabrication: A Practical Guide to Semiconductor Processing. McGraw Hill Publishing Co, 1997